# EUROPEAN PATENT APPLICATION

(11) **EP 4 625 049 A1**
(43) Date of publication of application: **01.10.2025**
(21) Application number: 25156381.3
(22) Date of filing: 06.02.2025
(51) Int. Cl.: G03F 7/20, G03F 7/00, H01L 21/027

(54) **METHODS AND APPARATUS TO REDUCE EXTREME ULTRAVIOLET LIGHT FOR PHOTOLITHOGRAPHY**

(30) Priority: 28.03.2024 US 202418620262
(71) Applicant: INTEL Corporation, Santa Clara, CA 95054 (US)
(72) Inventor: PAIK, Marvin, Portland, OR 97229 (US); WALLACE, Charles H., Portland, OR 97212 (US); GULER, Leonard, Hillsboro, OR 97124 (US); TAN, Elliot N., Portland, OR 97201 (US); LIU, Shengsi, Portland, OR 97229 (US); VISHWAKARMA, Vivek, Brush Priarie, WA 98606 (US); SAMEK, Izabela, Hillsboro, OR 97124 (US); SOLEYMANIHA, Mohammadreza, Cedar Park, TX 78613 (US)
(74) Representative: HGF

(57) **Abstract**

Apparatus and methods are disclosed. An example lithography apparatus includes an ultraviolet (UV) source to expose a photoresist layer to UV light; and an extreme ultraviolet (EUV) source coupled to the UV source, the EUV source to expose the photoresist layer to EUV light to via a photomask, a combination of the UV light and the EUV light provide a pattern on the photoresist layer when a developer solution is applied to the photoresist layer.

## Description

### FIELD OFTHE DISCLOSURE

This disclosure relates generally to semiconductor device fabrication and, more particularly, to methods and apparatus to reduce extreme ultraviolet light for photolithography.

### BACKGROUND

Semiconductor device fabrication includes various processes to manufacture integrated circuits or chips. Many processes involved in semiconductor device fabrication involve the use of photolithography. Photolithography involves the application of light onto a layer of light-sensitive material (e.g., a photoresist, also sometimes referred to simply as a resist) in a controlled manner to produce a pattern in the layer of material in which portions of the layer of material are retained while other portions are removed. Often, the exposure of light onto a photoresist is controlled through the use of a photolithography mask (e.g., a photomask or simply mask) between the light source and the photoresist.

### BRIEF DESCRIPTION OF THE DRAWINGS

FIG. 1 illustrates an example lithography apparatus in accordance with teachings of this disclosure.
FIG. 2 illustrates another example lithography apparatus disclosed herein.
FIG. 3 is a flowchart representing an example manufacturing process for patterning an example photoresist layer of an example wafer of FIGS. 1 and 2.
FIGS. 4A-4E are cross-sectional views depicting the example photoresist layer of the example wafer of FIG. 1 at various stages of manufacturing.
FIG. 5 is a block diagram of an example processing platform including programmable circuitry structured to execute, instantiate, and/or perform the example machine readable instructions and/or perform the example operations of FIG. 3 to implement the processor circuitry of FIG. 1.
FIG. 6 is a block diagram of an example implementation of the programmable circuitry of FIG. 5.
FIG. 7 is a block diagram of another example implementation of the programmable circuitry of FIG. 5.

In general, the same reference numbers will be used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some or all of these lines and/or boundaries may be idealized. In reality, the boundaries and/or lines may be unobservable, blended, and/or irregular.

### DETAILED DESCRIPTION

Semiconductor manufacturing often employs photolithography to form a pattern of an integrated circuit (IC) chip or printed circuit board. Often, extreme ultraviolet (EUV) light (e.g., ultraviolet light at a wavelength of approximately 13.5 nanometers (nm)) is used during photolithography manufacturing processes. EUV lithography can achieve ultra-fine feature sizes with a single exposure and/or can be used for scaling to even smaller feature sizes as IC chips continue to shrink in size, which surpasses limitations of traditional photolithography. Additionally, EUV lithography increases or improves manufacturing throughput by enabling faster wafer processing, leading to higher productivity. Although EUV lithography provides benefits over photolithography, EUV lithography is an expensive manufacturing process (e.g., the most expensive process) of semiconductor manufacturing. For example, to form a critical dimension (CD) of approximately 30.5 nanometers (nm) on a substrate employing EUV lithography requires approximately 92 millijoules (mJ) of energy.

Examples disclosed herein employ methods and apparatus to reduce a dose of EUV needed during EUV lithography manufacturing process(es). Reducing the dose needed for EUV lithography significantly reduces energy costs, equipment costs and, thus, manufacturing costs. To reduce costs, example methods and apparatus disclosed herein employ a combination of EUV light and ultraviolet light exposure (i.e., a dual-dose exposure) to achieve a critical dimension target during subsequent etching process(es). For example, example methods and apparatus disclosed herein expose a wafer or photoresist layer to an ultraviolet light to sensitize (e.g., alter solubility properties of) the photoresist layer followed by extreme ultraviolet light exposure for patterning the photoresist. Subsequent to the UV and EUV light exposure, a solution (e.g., a developer solution) can be applied to remove portions of the photoresist layer corresponding to a litho-pattern on the photoresist having to a desired critical dimension. Thus, example and apparatus disclosed herein employ a reduced EUV light dose. By applying UV light (e.g., a pre-dose or a post-dose) to a photoresist layer, an EUV dose can be significantly reduced, which can reduce manufacturing costs, increase manufacturing throughput, and/or reduce process/equipment cost.

Specifically, example methods and apparatus disclosed herein expose a wafer having an EUV resist layer or patterning mask (e.g., a chemically amplified resists (CAR)) to both UV light and EUV light. For example, the wafer (e.g., the resist on the wafer) is exposed to the UV light at a first instance in time and the wafer (e.g., the resist on the wafer) is exposed to EUV light at a second instance in time different than the first instance. In this manner, application of the UV light sensitizes (e.g., alters a solubility characteristic of) the resist layer to reduce energy needed by EUV light for patterning the resist layer. Specifically, applying UV light reduces an amount of EUV light exposure needed to pattern the photoresist. For example, to form a critical dimension (CD) of approximately 30.5 nanometers (nm) on a substrate employing a combination of UV light and EUV light requires approximately 55 millijoules (mJ) of energy, which is approximately 35 millijoules (mJ) less than applying solely EUV light (e.g., absent the application of the UV light) for providing the same critical dimension. Thus, application of the UV light reduces the dose of EUV light needed to pattern the photoresist, thereby reducing manufacturing costs. In some examples, the UV light is applied to the wafer (e.g., the resist or mask layer of the wafer) prior to application of the EUV light. In some examples, the EUV light is applied to the wafer (e.g., the resist or mask layer of the wafer) prior to application of the UV light. The order in which the UV light and the EUV light is applied to the wafer does not have a significant or material impact on the final patterning or critical dimension target of a wafer.

Moreover, example methods and apparatus disclosed herein can be employed with EUV resists based on traditional chemically amplified resists (CAR) that are sensitive to UV light. In this manner, no special operations and/or materials are needed. Conventional or known EUV resists can be employed and a pattern (e.g., on a photoresist) can be provided based solely on a dual exposure to UV light and EUV light. In other words, example lithography apparatus disclosed herein can pattern a photoresist based on combination of UV/EUV without all the complexity of special operations and materials (i.e., a specially designed resist that includes a photoacid generator, a photo sensitizer, and a photo-base generator). Thus, example methods and apparatus disclosed herein significantly simply lithography manufacturing and significantly reduce manufacturing costs.

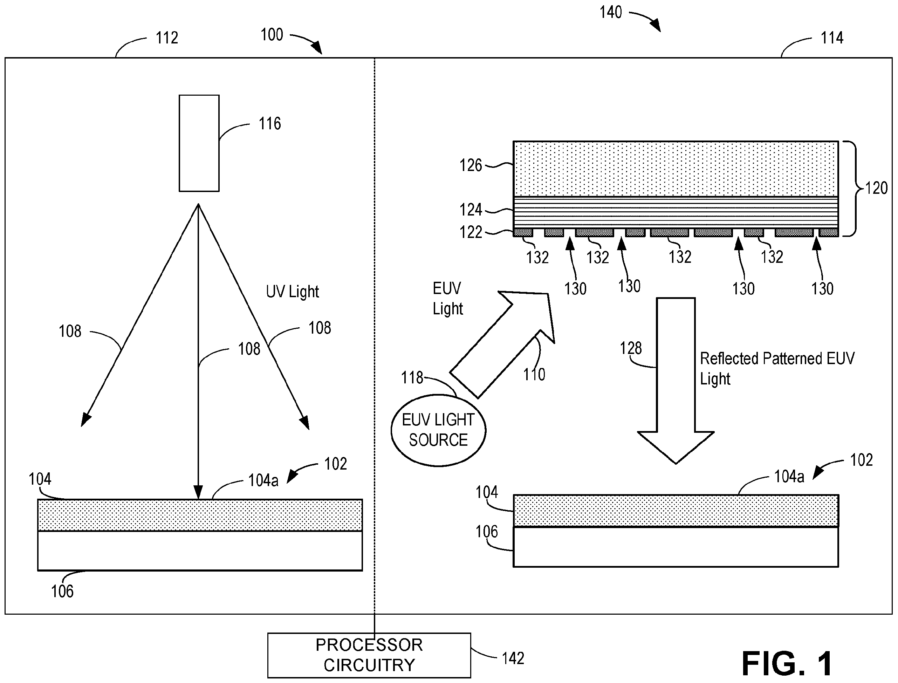

FIG. 1 illustrates an example lithography apparatus 100 in accordance with teachings of this disclosure. The lithography apparatus 100 can be employed to provide a pattern (e.g., a circuit) on an example wafer 102. The wafer 102 of the illustrated example includes a layer of light-sensitive material or photoresist 104 (e.g., a photoresist layer) on some underlying layer or substrate 106. In some examples, the underlying substrate 106 is silicon. In some examples, the underlying substrate 106 is a conductive material (e.g., metal). In some examples, the underlying substrate 106 is a dielectric material (e.g., an organic dielectric). In some examples, the underlying substrate 106 is a solid piece of glass (e.g., a glass pane, panel, or sheet). In some examples, the glass substrate includes at least one of: aluminosilicate, borosilicate, alumino-borosilicate, silica, and/or fused silica. In some examples, the glass substrate includes one or more additives including: aluminum oxide (Al2O3), boron trioxide (B2O3), magnesia oxide (MgO), calcium oxide (CaO), stoichiometric silicon oxide (SrO), barium oxide (BaO), stannic oxide (SnO2), sodium oxide (Na2O), potassium oxide (K2O), phosphorus trioxide (P2O3), zirconium dioxide (ZrO2), lithium oxide (Li2O), titanium (Ti), and/or zinc (Zn). In some examples, the glass substrate includes silicon and oxygen. In some examples, the glass substrate includes silicon, oxygen and/or one or more of aluminum, boron, magnesium, calcium, barium, tin, sodium, potassium, strontium, phosphorus, zirconium, lithium, titanium, and/or zinc. In some examples, the glass substrate includes at least 13 percent silicon by weight and at least 16 percent oxygen by weight. In some examples, the glass substrate is a layer of glass including silicon, oxygen, and aluminum. In some examples, the glass substrate includes at least 13 percent silicon by weight, at least 16 percent oxygen by weight, and at least 5 percent aluminum by weight. In some examples, the glass substrate is an amorphous solid glass layer. In some examples, the underlying substrate 106 is composed of a material other than glass and/or silicon.

In some instances, the underlying substrate 106 corresponds to a portion of an IC package. More particularly, in some instances, the underlying substrate 106 corresponds to a particular layer within a semiconductor die (e.g., an IC chip or chiplet) within the IC package, a particular layer within a package substrate for the IC package, and/or any other suitable substrate. Example semiconductor dies or chiplets (e.g., tiles) provided by the examples disclosed herein can implement controllers, microprocessors, Digital Signal Processors (DSPs), Central Processor Units (CPUs), Graphics Processor Units (GPUs), programmed microprocessors, Field Programmable Gate Arrays (FPGAs), Application Specific Integrated Circuits (ASICs), Reduced Instruction Set Computers (RISCs), any other circuitry and/or combinations thereof. Additionally, example semiconductor dies can be chiplets of a disaggregated die. Each chiplet (also referred to as a tile) may implement a dedicated function. Together, the chiplets may implement a complex circuitry. The complex circuitry can be any type of device that can be implemented as a plurality of chiplets that are physically separated from, but communicatively coupled to, one another. For example, processor circuitry may be implemented by two or more separate chiplets that together implement a microprocessor, etc. Alternatively, in other examples, example semiconductor dies may be different chips (e.g., a processor circuitry, a memory, and/or or some other type of component) that together implement a system on a chip (SoC) in a semiconductor package.

To provide a pattern corresponding to circuitry of the substrate 106, the photoresist 104 is patterned to define openings (e.g., formed in a later process) in the photoresist 104 that can then be used as a mask to create corresponding openings in the underlying substrate 106 (e.g., through an etching process that removes portions of the underlying substrate exposed through the openings in the photoresist 104). In some instances, instead of removing portions of the underlying substrate 106 exposed through the openings in the photoresist 104, the openings in the photoresist 104 can be filled with a material to be added onto the underlying substrate 106 at the locations defined by the openings. In some instances, the photoresist 104 is removed after subsequent processing associated with the use of the patterned openings have been completed. In other instances, the photoresist 104 is retained on the underlying substrate 106 and remains as part of the final product (e.g., some portion of an IC package).

To provide the lithography patterning on the substrate 106, the lithography apparatus 100 disclosed herein exposes the wafer 102 (e.g., the substrate 106 and/or the photoresist 104) to an ultraviolet (UV) light 108 and an extreme ultraviolet (EUV) light 110. For example, the UV light 108 can have a wavelength in the range of 100s of nanometers (nm) depending on the technique used to produce the UV light 108 (e.g., approximately, 248nm (KrF), approximately 365 nm (i-line light), approximately 405 nm (g-line light), approximately 435 nm (h-line light), etc.) and the EUV light 110 can have a wavelength that is significantly shorter (e.g., approximately 13.5 nm). To provide the UV light 108, the example lithography apparatus 100 includes an example ultraviolet (UV) source 112 (e.g., a UV applicator, a UV light source, a UV station). To provide the EUV light 110, the example lithography apparatus 100 includes an example extreme ultraviolet (EUV) source 114 (e.g., an EUV applicator, a EUV station, an EUV light source, etc.).

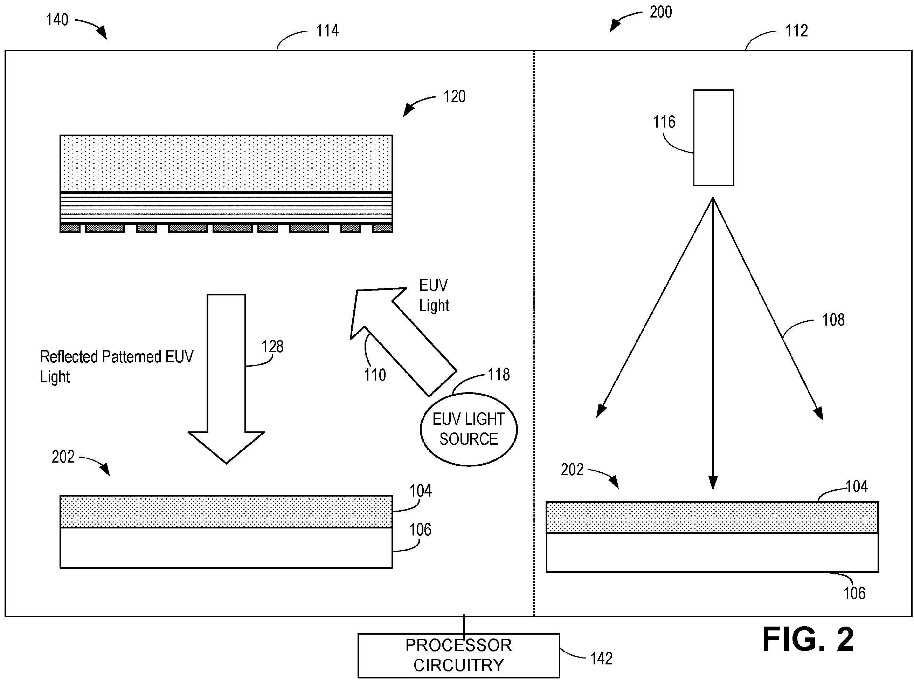

In the illustrated example, the UV source 112 provides a pre-dosing of ultraviolet (UV) light on the photoresist 104 and the EUV source 114 provides a patterned exposure on portions of the photoresist 104 exposed to the EUV light to create (e.g., finalize) a pattern of openings (e.g., a lithography pattern) on the photoresist 104 (e.g., using a reduced EUV dose relative to what would otherwise be needed in the absence of the pre-dosing of the UV light). However, in some examples, the EUV source 114 and the UV source 112 can be reversed (see, for example, FIG. 2). Specifically, the EUV source 114 can be configured to provide a patterned exposure on the photoresist 104 first and the UV source 112 be used subsequently to the EUV source 114 to sensitize portions of the photoresist 104 exposed to the UV light. Thus, regardless of order or application, the UV light 108 provided by the source 112 source and the EUV light 110 provided by the EUV source 114 sensitizes the photoresist 104 to create a pattern on the photoresist 104 using a lower EUV dose from the EUV source 114. Thus, both the UV light 108 and the EUV light 110 sensitize the photoresist 104.

As used herein, to sensitize the photoresist 104 means to change a solubility characteristic of the photoresist 104. For example, the photoresist 104 can be a positive photoresist or a negative photoresist. In a positive photoresist, the UV light 108 and the EUV light 110 weaken exposed areas of the photoresist 104, thereby increasing solubility characteristics of the exposed areas of the photoresist 104 in a developer solution (e.g., the developer solution dissolves the exposed areas leaving a pattern of non-exposed areas where the mask was placed). In a negative photoresist, the UV light 108 and the EUV light 110 strengthen (e.g., polymerizing or cross-linking) exposed areas of the photoresist 104, thereby making the exposed areas insoluble in a developer solution (e.g., the developer solution dissolves away only the areas that were not exposed to the UV light 108 and the EUV light 110, leaving a pattern where the mask was not placed). Thus, depending on type of photoresist material, exposing the photoresist 104 to the UV light 108 can weaken (e.g., soften) or harden the photoresist 104.

Resist materials defining the photoresist 104 can be different types of EUV resist materials based on traditional chemically amplified resists (CAR) that are sensitive to UV light in addition to EUV light. Thus, conventional or known resist materials can be employed. Some example photoresist materials that can be used include, but not limited to, diazo-naphthoquinone (DNQ), metal containing resists such as, for example, hafnium oxide nanoparticles, zirconium oxide nanoparticles, hafnium-based photoresists, and/or any other suitable material(s).

To expose the wafer 102 to the UV light 108, the UV source 112 of the illustrated example includes a UV light source 116 that provides the UV light 108 (e.g., wavelengths of 100s nanometers (nm) (e.g., 365nm, 405nm, 435nm, etc.)). The UV light source 116 can be a flood light, an UV LED, vapor light, fluorescent light, a halogen light, and/or any other light or bulb that emits ultraviolet light. The UV light source 116 of the UV source 112 emits, disperses, or otherwise scatters (e.g., a first dose of) the UV light 108 directed at the photoresist 104 after the photoresist 104 is layered on the substrate 106. Specifically, the UV light 108 provided by the UV source 112 of the illustrated example is applied across a surface 104a (e.g., an entire surface area or upper surface) of the photoresist 104. In some instances, the UV light 108 is spread uniformly (e.g., evenly distributed) across the surface 104a. That is, in some examples, the photoresist 104 is exposed to the UV light 108 without a mask positioned between the light source 116 and the photoresist 104. In some examples, the UV light 108 is spread in a non-unform pattern across the surface 104a of the photoresist 104. In some examples, the UV light 108 (e.g., a first dose of UV light) is a flood exposure (e.g., provided by a flood light). Additionally, the UV source 112 of the illustrated example exposes the photoresist 104 to the UV light 108 prior to the EUV source 114 exposing the photoresist 104 with the EUV light 110. Thus, the UV source 112 of the illustrated example provides a pre-dose of the UV light 108 on the photoresist 104. Providing a pre-dose of the UV light 108 sensitizes (e.g., softens, weakens, or hardens) the photoresist 104. As a result, a lower dose of the EUV light 110 is needed to provide a pattern of openings (e.g., a lithography pattern) on the wafer 102 (e.g., with a desired critical dimension target). Thus, because the photoresist 104 of the illustrated example is sensitive to light, the UV light 108 provided by the UV source 112 provides structural changes to (e.g., alters solubility characteristics of) the photoresist 104 (e.g., exposure to light either softens or hardens the photoresist 104). Although the UV light 108 provided by the UV source 112 changes or alters a physical characteristic of the photoresist 104, the UV light 108 does not pattern the openings on the photoresist 104. That is, in some examples, the changes or alterations to the photoresist 104 caused by the pre-dose of the UV light 108 are insufficient by themselves to result in the removal of any portion(s) of the photoresist 104 when a developer solution is applied. However, the UV light 108 enables a reduced dose of the EUV light 110 needed to be applied to the photoresist 104 to affect sufficient changes or alterations to the photoresist 104 to be patterned with portion(s) removed during a development process. Thus, the UV light 108 contributes to achieving (e.g., in combination with the EUV light 110) a desired critical dimension (CD) of the pattern openings on the photoresist 104. In other words, the combination of the EUV light 110 and UV light 108 exposure to the photoresist 104 provides or establishes (e.g., a critical dimension target or control of) the pattern (e.g., the pattern openings) of the photoresist 104.

Different wavelengths of the UV light 108 can be evaluated and/or determined for a specific type of resist material defining the photoresist 104. Therefore, different resist materials and/or UV light wavelengths can be used for different applications. After pre-dosing the wafer 102 with the UV light provided by the UV source 112, the wafer 102 is processed by the EUV source 114. Pre-dosing the wafer 102 with the UV light 108 enables the EUV source 114 to provide a pattern of openings on the wafer 102 (e.g., with a target critical dimension) using a lower dose (e.g., lower energy) than processing the wafer 102 without the pre-dose UV light (e.g., to achieve the same critical dimension target).

After the wafer 102 is processed by the UV source 112, a pattern of openings is provided on the photoresist 104 via the EUV source 114. To provide a pattern of openings on the photoresist 104, the EUV source 114 includes an example photomask 120 (or simply mask) to photolithographically pattern the photoresist 104 on the substrate 106. The EUV source 114 of FIG. 1 is an extreme ultraviolet (EUV) lithography system. Accordingly, the EUV source 114 includes an EUV light source 118 that produces the EUV light 110. More particularly, the EUV light source 118 can be a laser driven light source (e.g., based on tin plasma) that produces extreme ultraviolet (EUV) light (e.g., ultraviolet light at a wavelength of approximately 13.5 nanometers (nm)). As shown in FIG. 1, the EUV light 110 is directed towards the photomask 120. The photomask 120 includes an absorber layer 122 (also referred to herein simply as an absorber) having a defined pattern on an outer surface of a multilayer region 124 (also referred to herein simply as a multilayer). The absorber 122 is an opaque material capable of absorbing the EUV light 110. In some examples, the absorber 122 is implemented with chromium. However, the absorber 122 can be implemented using any other suitable opaque material. The multilayer 124 is defined by a stack of thin films or layers of materials capable of reflecting the EUV light 110. More particularly, in some examples, the multilayer 124 includes alternating layers of molybdenum and silicon.

As shown in FIG. 1, both the patterned absorber 122 and the multilayer 124 are carried by a support substrate 126. In some examples, the support substrate 126 is a solid piece of glass (e.g., a glass pane, panel, or sheet). In some examples, the glass substrate includes at least one of: aluminosilicate, borosilicate, alumino-borosilicate, silica, and/or fused silica. In some examples, the glass substrate includes one or more additives including: aluminum oxide (Al2O3), boron trioxide (B2O3), magnesia oxide (MgO), calcium oxide (CaO), stoichiometric strontium oxide (SrO), barium oxide (BaO), stannic oxide (SnO2), sodium oxide (Na2O), potassium oxide (K2O), phosphorus trioxide (P2O3), zirconium dioxide (ZrO2), lithium oxide (Li2O), titanium (Ti), and/or zinc (Zn). In some examples, the glass substrate includes silicon and oxygen. In some examples, the glass substrate includes silicon, oxygen and/or one or more of aluminum, boron, magnesium, calcium, barium, tin, sodium, potassium, strontium, phosphorus, zirconium, lithium, titanium, and/or zinc. In some examples, the glass substrate includes at least 13 percent silicon by weight and at least 16 percent oxygen by weight. In some examples, the glass substrate is a layer of glass including silicon, oxygen and aluminum. In some examples, the glass substrate includes at least 13 percent silicon by weight, at least 16 percent oxygen by weight, and at least 5 percent aluminum by weight. In some examples, the glass substrate is an amorphous solid glass layer. In some examples, the support substrate 126 is composed of a material other than glass.

As the EUV light 110 reaches the photomask 120, the absorber 122 absorbs the EUV light 110. The reflective films within the multilayer 124 reflect at least a portion of the EUV light 110 (referred to herein as reflected patterned EUV light 128) that is directed toward the photoresist 104. The reflected patterned EUV light 128 is defined by the pattern of the absorber 122. That is, as shown in FIG. 1, the pattern of the absorber 122 is defined by openings 130 between opaque regions 132 of the absorber 122. The opaque regions 132 absorb at least a portion of the EUV light 110 so that the absorbed portion of the EUV light 110 is not reflected towards the photoresist 104. The openings 130 expose portions of the underlying multilayer 124 and the exposed portions of the multilayer 124 will reflect at least a portion of the EUV light 110 (e.g., the reflected patterned EUV light 128) towards the photoresist 104.

In the illustrated example, the photoresist 104 is a photo-sensitive material such that the portions of the photoresist 104 exposed to the reflected patterned EUV light 128 will react to the light and change characteristics. Specifically, in some instances, the photoresist 104 exposed to light will harden such that when a developer solution is applied to the photoresist 104, the portions that remain relatively soft (e.g., the portions not exposed to the EUV light 110) will be removed while the hardened portions will remain. In this manner the pattern defined by the opaque regions 132 of the absorber 122 on the photomask 120 are transferred to the photoresist 104. In other instances, the portions of the photoresist 104 exposed to the reflected EUV light 128 change so that they remain when a developer solution is applied while the rest of the photoresist 104 is removed. In this manner the pattern defined by the openings 130 in the absorber 122 (e.g., the inverse of the pattern defined by the opaque regions 132) is transferred to the photoresist 104.

In operation, the lithography apparatus 100 of the illustrated example reduces energy use of the EUV source 114. As an example, the lithography apparatus 100 can provide an example critical dimension target of approximately 30.5 nanometers using less energy than would be required without the use of the UV source 112. For example, the EUV source 114 can provide the critical dimension target of approximately 30.5 nanometers using approximately 55 millijoules when pre-dosing the wafer 102 with the UV light 108 provided by the UV source 112. In contrast, the EUV source 114 would require approximately 95 millijoules to provide a critical dimension target of approximately 30.5 nanometers absent the pre-dose of the UV light 108. In other words, employing the UV light 108 in combination with the EUV light 110 enables a dose of EUV light 110 that is between approximately 35 percent and 45 percent (e.g., 40 percent) less to establish a desired critical dimension as a result of the UV light exposure. Additionally, compared to the EUV source 114 (which uses approximately 55 millijoules (mJ)), the UV source 112 uses less energy (e.g., approximately 10 millijoules (mJ)). Moreover, the UV light source 116 employs a light bulb (e.g., a flood light) that is significantly less expensive than a light source of the EUV light source 118 generating the EUV light 110. Thus, the lithography apparatus 100 disclosed herein significantly reduces manufacturing costs, equipment costs, and can provide a higher throughput of wafer production.

Furthermore, the lithography apparatus 100 of the illustrated example can configure the UV source 112 and the EUV source 114 in a single unit or equipment (e.g., a single enclosed housing defining a machine or equipment) and/or in a semiconductor manufacturing track to provide consistent wafer-to-wafer processing times and conditions. Thus, in some examples, the UV source 112 and the EUV source 114 are provided in a single housing or the same housing structure. By providing the UV source 112 and the EUV source 114 in a semiconductor manufacturing track or a link (e.g., as a single manufacturing operating process), the lithography apparatus 100 reduces delay between the UV light application and the EUV light application, thereby providing consistent and/or uniform UV exposure to EUV exposure time and resulting in more consistent wafer output. For example, providing the UV source 112 and the EUV source 114 inside a track enables more consistent exposure time, and/or time between exposures, resulting in more consistent critical dimension and/or critical dimension control. If the UV source 112 is separate from the EUV source 114 requiring transfer of the wafer 102 to the different sources (e.g., separate operating processes), such delay between the pre-dose of UV light and the EUV exposure could be significant and can provide inconsistencies between wafers. For example, separating the pre-dose UV light and the EUV light applications can result in less critical dimension control, resulting in inferior results and/or critical dimension control. Thus, the UV source 112 and the EUV source 114 are to be provided in the semiconductor manufacturing track, where the UV source and the EUV source are linked in the semiconductor manufacturing track to provide steady wafer-to-wafer processing times and conditions. After the EUV source 114 exposes the photoresist 104 to the EUV pattern, the photoresist 104 can be processed by a developer solution to form the pattern provided by the photomask 120. After formation of the pattern, the wafer 102 can be processed using any suitable manufacturing process(es) on the exposed portions of the substrate 106 (e.g., etching the substrate 106, depositing material(s) onto the substrate, etc.) based on the litho-pattern developed by the lithography apparatus 100.

In some examples, the lithography apparatus 100 of FIG. 1 (e.g., the UV source 112 and the EUV source 114) can be a part of a semiconductor manufacturing track 140. As used herein, a semiconductor manufacturing track refers to a sequence of interconnected processes involved in producing semiconductor devices. These processes result in the production of integrated circuits (ICs) and other electronic components. More specifically, the semiconductor manufacturing track 140 disclosed herein is provided on a front-end manufacturing track. Front-end manufacturing is also known as wafer fabrication and this phase involves production of semiconductor devices on silicon wafers (e.g., the wafer 102). Some of the processes involved with the semiconductor manufacturing track 140 (e.g., a front-end track) include, but are not limited to, deposition, photoresist, lithography, etching, ion implantation and packaging, For example, during a deposition process, thin layers of materials (such as silicon dioxide or metal) are deposited onto a wafer surface (e.g., substrate 106) using techniques like chemical vapor deposition (CVD) or physical vapor deposition (PVD). During a photoresist process, a light-sensitive material (e.g., the photoresist 104) is applied to an underlying substrate (e.g., the substrate 106), allowing for precise patterning during subsequent steps. During a lithography process, patterns (e.g., pattern openings) are transferred onto a photoresist (e.g., the photoresist 104) using photomasks and exposure to light. During an etching process, unwanted material is selectively removed from a wafer or substrate (e.g., the wafer 102 or the substrate 106) using plasma etching or wet etching. During an ion implantation process, ions are implanted into a wafer (e.g., the wafer 102 or the substrate 106) to modify its electrical properties. During a packaging process, individual chips are separated from the wafer and packaged for use in electronic devices.

In some examples, the semiconductor manufacturing track 140 can be a unitary system (e.g., a single piece of equipment) with different stations or units within the unitary system to provide the different front-end manufacturing processes including deposition, photoresist, lithography, etching, ion implantation and packaging. In such examples, each of the front-end manufacturing processes (e.g., deposition, photoresist, lithography, etching, ion implantation and packaging) are operatively coupled or interconnected via a track, in which the track moves a wafer (e.g., the wafer 102) between the different stations within the single unit or equipment. In some examples, each of the front-end manufacturing processes (e.g., deposition, photoresist, lithography, etching, ion implantation and packaging) are provided by different or standalone pieces of equipment that are operatively coupled via the track.

In some examples, the lithography apparatus 100 (e.g., the UV source 112 and the EUV source 114) can be used to implement a lithography process in the example semiconductor manufacturing track 140 noted above (e.g., the front-end manufacturing process). For example, the lithography apparatus 100 can be located between the photoresist process and the etching process of the example front-end manufacturing track noted above. Thus, the lithography apparatus 100 of the illustrated example can be located downstream from a photoresist unit or equipment and upstream from an etching unit or equipment.

In some examples, the lithography apparatus 100 of the illustrated example is implemented with example processor circuitry 142 (e.g., a controller, a processor, a microprocessor, etc.). In some examples, the processor circuitry 142 is omitted. The example processor circuitry 142 of the illustrated example can be configured to: identify (e.g. access) data indicating a type of photoresist material of the photoresist, determine a UV dosage and/or EUV dosage needed to pattern the photoresist 104 based on the identified photoresist material, control the UV light source 116 and/or the EUV light source 118 (e.g., an intensity of the UV light and/or the EUV light, and/or duration of exposure to the UV light and/or the EUV light), and/or cause the wafer 102 to move between the UV source 112 and the EUV source 114 and/or to/from the UV source 112, and/or the EUV source 114.

In some examples, the processor circuitry 142 can control or command a transmission system (e.g., a motor) of the semiconductor manufacturing track 140 to move the wafer 102 relative to the lithography apparatus 100. For example, the processor circuitry 142 of the illustrated example can command the semiconductor manufacturing track 140 to convey the wafer 102 from a station (e.g., a photoresist process station) upstream from the lithography apparatus 100 to advance the wafer 102 to the lithography apparatus 100. Likewise, after exposure by the lithography apparatus 100, the controller 142 of the illustrated example can command the semiconductor manufacturing track 140 to convey or advance the wafer 102 from the lithography apparatus 100 (e.g., a photoresist process station) to a station (e.g., an etching station, a baking station, etc.) downstream from the lithography apparatus 100.

In some examples, the processor circuitry 142 of the illustrated example can control a duration and/or intensity of the UV light 108 and/or the EUV light 110 as the wafer 102 is processed by the lithography apparatus 100. For example, the processor circuitry 142 of the illustrated example can be communicatively coupled to the UV light source 116 and the EUV light source 118 and can send a signal (e.g., a current or voltage signal) to adjust (e.g., increase or decrease) an intensity of UV light source 108 and/or an intensity of the EUV light source 110. In some examples, the processor circuitry 142 can command or operate a motor of the semiconductor manufacturing track 140 to control a duration of photoresist exposure to the UV light 108 and/or the EUV light 110.

In some examples, the processor circuitry 142 can be configured to identify or access data (e.g., from a look-up table, memory, photo analysis, etc.) to determine or detect a type of photoresist material and command or control (e.g., adjust a current or voltage to) the UV light source 116 and/or the EUV light source 118 to adjust (e.g., increase or decrease) an intensity (e.g., a brightness) of the UV light 108 and/or the EUV light 110 needed to provide the pattern (e.g., a critical dimension target) on the photoresist layer 104 based on the identified photoresist layer 104. In some examples, the processor circuitry 142 can commend or control operation of a track of the semiconductor manufacturing track 140 to control a duration of exposure to the UV light 108 and/or the EUV light 110 that would be needed to provide the pattern (e.g., a critical dimension target) on the photoresist layer 104 based on the identified photoresist material of the photoresist layer 104.

In some examples, controlling intensity and/or exposure time can provide consistent and/or superior manufacturing results. For example, linking the UV source 112 and the EUV source 114 in a semiconductor manufacturing track provides consistent first dose-to-second dose exposure time to improve wafer-to-wafer processing. In some examples, the processor circuitry 142 can be employed to provide consistent first dose-to-second dose exposure time to improve wafer-to-wafer processing.

The processor circuitry 142 of FIG. 1 may be instantiated (e.g., creating an instance of, bring into being for any length of time, materialize, implement, etc.) by programmable circuitry such as a Central Processor Unit (CPU) executing first instructions. Additionally or alternatively, the processor circuitry 142 of FIG. 1 may be instantiated (e.g., creating an instance of, bring into being for any length of time, materialize, implement, etc.) by (i) an Application Specific Integrated Circuit (ASIC) and/or (ii) a Field Programmable Gate Array (FPGA) structured and/or configured in response to execution of second instructions to perform operations corresponding to the first instructions. It should be understood that some or all of the circuitry of FIG. 1 may, thus, be instantiated at the same or different times. Some or all of the circuitry of FIG. 1 may be instantiated, for example, in one or more threads executing concurrently on hardware and/or in series on hardware. Moreover, in some examples, some or all of the circuitry of FIG. 1 may be implemented by microprocessor circuitry executing instructions and/or FPGA circuitry performing operations to implement one or more virtual machines and/or containers.

Furthermore, the processor circuitry 142 may be implemented by hardware alone or by hardware in combination with software and/or firmware. Thus, for example, the processor circuitry 142, could be implemented by programmable circuitry in combination with machine readable instructions (e.g., firmware or software), processor circuitry, analog circuit(s), digital circuit(s), logic circuit(s), programmable processor(s), programmable microcontroller(s), graphics processing unit(s) (GPU(s)), digital signal processor(s) (DSP(s)), ASIC(s), programmable logic device(s) (PLD(s)), and/or field programmable logic device(s) (FPLD(s)) such as FPGAs.

FIG. 2 is another example lithography apparatus 200 disclosed herein. Many of the components of the example lithography apparatus 200 of FIG. 2 are substantially similar or identical to the components described above in connection with the lithography apparatus 100 of FIG. 1. As such, those components will not be described in detail again below. Instead, the interested reader is referred to the above corresponding descriptions for a complete written description of the structure and operation of such components. To facilitate this process, similar or identical reference numbers will be used for like structures in FIG. 2 as used in FIG. 1. For example, the lithography apparatus 200 of FIG. 2 includes a UV source 112 and an EUV source 114.

The lithography apparatus 200 of the illustrated example is substantially similar or identical to the lithography apparatus 100 of FIG. 1 except that the lithography apparatus 200 exposes a wafer 202 having a substrate 106 and a photoresist 104 to the UV light 108 after the photoresist 104 is exposed to an EUV light 110. Thus, the order (e.g., the order of operation) of the UV source 112 and the EUV source 114 are reversed compared to the lithography apparatus 100 of FIG. 1. Therefore, the EUV source 114 provides EUV pattern exposure to the photoresist 104 (e.g., a litho-pattern) prior to exposing the photoresist 104 to the UV light 108 (e.g., post-sensitization). Subsequent to EUV exposure, the lithography apparatus 200 of FIG. 2 exposes the photoresist 104 to the UV light 108. Thus, the UV source 112 provides a post-dose of the UV light 108 to the photoresist 104. The combination of the EUV light 110 and UV light 108 exposure to the photoresist 104 provides or establishes a critical dimension target or control of the pattern openings (e.g., the pattern) of the photoresist 104. Subsequent to the UV light 108 exposure, the photoresist 104 can be processed by a developer solution to form the pattern provided by a photomask 120. Although the UV light 108 may be exposed across the entire surface of the photoresist 104 (e.g., no mask is used), the UV exposure is at a dosage that is insufficient to cause the photoresist 104 to change adequately to be removed by the developer solution except at the locations exposed to the patterned EUV light 128. After formation of the pattern, the wafer 202 can be processed using any suitable manufacturing process(es) on the exposed portions of the substrate 106 (e.g., etching the substrate 106, depositing material(s) onto the substrate, etc.) based on the litho-pattern developed by the lithography apparatus 200.

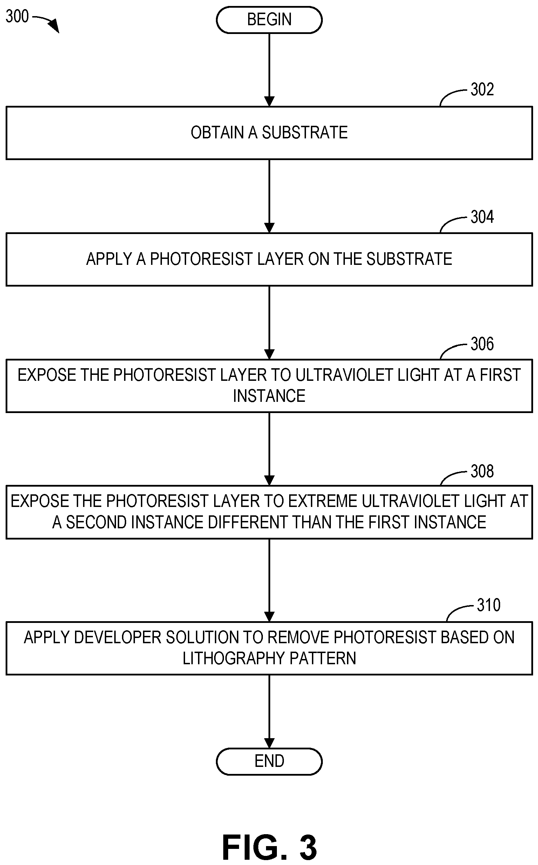

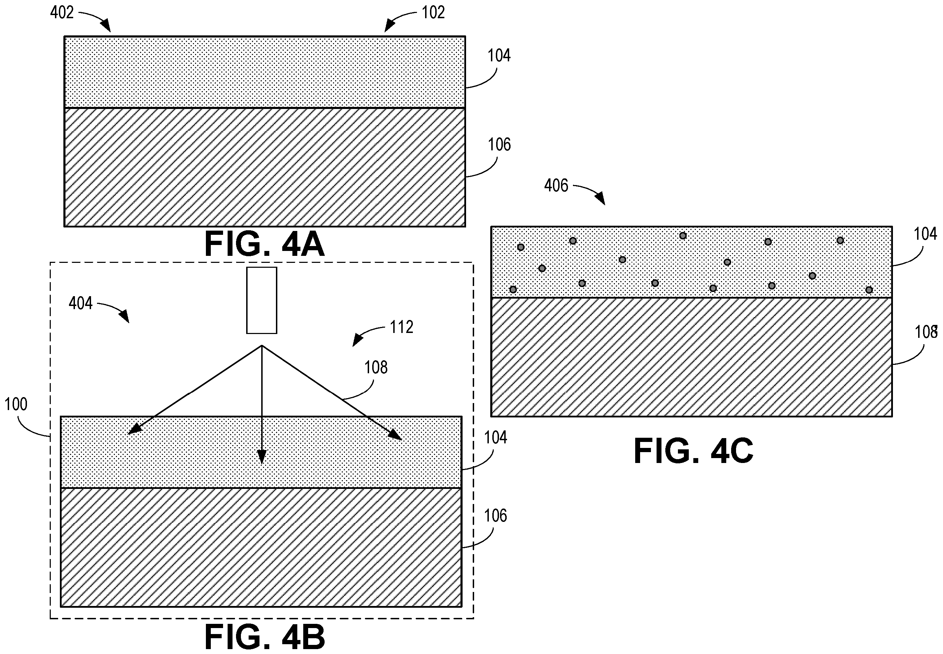

FIG. 3 is a flowchart of an example method 300 of processing an example wafer (e.g., the wafer 102 of FIG. 1). To facilitate discussion of the example method 300, the example method 300 is described in connection with the example wafer 102 and the lithography apparatus 100 of FIG. 1. For example, FIGS. 4A-4E are cross-sectional schematic illustrations of the example wafer 102 of FIG. 1 at various manufacturing stages 402, 404, 406, 408, 410, corresponding to the example method 300 of FIG. 3. While an example manner of processing the example wafer 102 has been illustrated in FIGS. 3 and 4A-4E, one or more of the operations and/or processes illustrated in FIGS. 3 and 4A-4E may be combined, divided, re-arranged, omitted, eliminated and/or implemented in any other way. Further still, the example methods of FIGS. 3 and 4A-4E may include processes and/or operations in addition to, or instead of, those illustrated in FIGS. 3 and 4A-4E and/or may include more than one of any or all of the illustrated processes and/or operations. Referring to the example method 300 of FIG. 3, the method 300 begins by obtaining a substrate (block 302). For example, the substrate 106 can be a silicon substrate, a glass substrate, a dielectric substrate, a metal substrate, and/or any other suitable underlying substrate.

Next, a photoresist layer is applied to the substrate (block 304). For example, referring to FIG. 4A, the photoresist 104 can be a coating or layer of light-sensitive material (e.g., organic material) that can be provided or applied to the substrate 106 (e.g., to define the wafer 102). For example, the photoresist 104 material can be applied to the substrate 106 via spin coating (e.g., a liquid photoresist is applied to the substrate 106 while spinning) and/or any other manufacturing techniques and/or any other semiconductor manufacturing process(es).

After the photoresist is applied to the substrate at block 304, the photoresist is exposed to an ultraviolet light at a first instance (block 306). For example, referring to FIG. 4B and FIG. 4C, the wafer 102 and/or the photoresist 104 is applied with a pre-dose of UV light 108 to alter the structural characteristics (e.g., solubility) of the photoresist 104. For example, the wafer 102 and/or the photoresist 104 is processed by the lithography apparatus 100 of FIG. 1. More specifically, the wafer 102 and/or the photoresist 104 is processed by the UV source 112 of the lithography apparatus 100 of FIG. 1. In particular, the UV source 112 exposes the photoresist 104 to the UV light 108. The UV light 108 is scattered or applied uniformly across the surface 104a of the photoresist 104, which alters the characteristics (e.g., solubility characteristics) of the photoresist 104 compared to the characteristics of the photoresist 104 prior to exposure to the UV light 108. The UV light 108 sensitizes the photoresists 104.

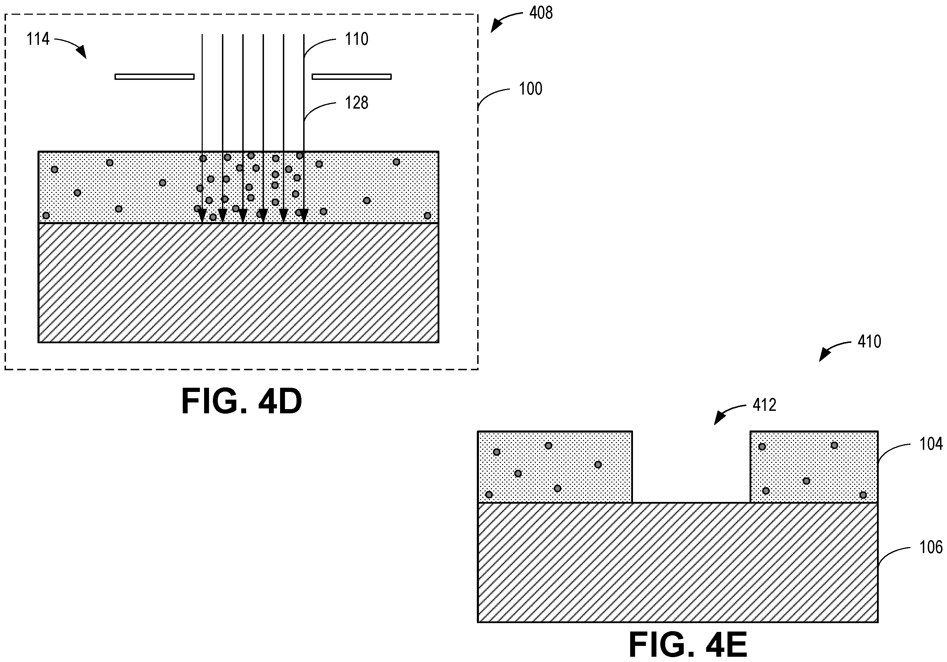

After the photoresist 104 is sensitized by the UV light, the photoresist is exposed to extreme ultraviolet light at a second instance different than the first instance (block 308). For example, referring to FIG. 4D, the wafer 102 and/or the photoresist 104 is processed by the lithography apparatus 100 of FIG. 1. More specifically, the wafer 102 and/or the photoresist 104 is processed by the EUV source 114. In particular, the EUV source 114 exposes the photoresist 104 to the EUV light 110 to provide a pattern on the photoresist 104 corresponding to the pattern of the photomask 120. As a result of the UV light pre-dose of block 306, the EUV source 114 can provide the EUV light 110 with less energy. For example, the EUV light 110 can be applied at 55 millijoules compared to 90 millijoules (e.g., a reduction of 35 millijoules) to provide a critical dimension litho-pattern of approximately 30.5 nanometers when the photoresist 104 is predosed with UV light 108 in block 306. Thus, the example method 300 of FIG. 3 can reduce a dose of the EUV light by approximately 40 percent to provide a pattern on the photoresist 104 at a desired critical dimension target compared to a dose of EUV light needed to provide the pattern with the desired critical dimension target absent exposure of the UV light 108.

After the photoresist is patterned with a lithography pattern, a pattern is formed on the photoresist (block 310) (e.g., one or more openings are formed in the photoresist). For example, referring to FIG. 4E, pattern openings 412 are formed in the photoresist 104. In some examples, following exposure, the wafer 102 undergoes a post-exposure process (e.g., a post-exposure bake) to further stabilize the photoresist (e.g., enhance a contrast between EUV exposed and EUV unexposed regions of the photoresist 104 corresponding to the pattern provided by the photomask 120). To form the pattern opening, in some examples, the wafer 102 can be immersed in a developer solution that selectively removes either the UV light and EUV light exposed areas or the UV light or EUV light unexposed areas of the photoresist 104 corresponding to the pattern provided by the EUV source 114. For example, for a positive photoresist, the UV light and EUV light exposed areas dissolve away when the wafer 102 is immersed in the developer solution. For a negative photoresist, the UV light and the EUV light unexposed areas are removed.

After pattern formation, the wafer 102 can undergo further processing for producing semiconductor devices. For example, the wafer 102 can continue to undergo further conventional manufacturing processes including, but not limited to, plasma etching, laser drilling, laser etching, polishing, integrated circuit microfabrication processes, wet etching, dry etching, anisotropic etching, spin coating, electroforming or electroplating, laser ablation, sputtering, chemical deposition, plasma deposition, surface modification, injection molding, hot embossing, thermoplastic fusion bonding, low temperature bonding using adhesives, stamping, machining, 3-D printing, laminating, and/or any other processes commonly used for manufacture of semiconductor devices.

In the example method 300 of FIG. 3, block 306 is prior to block 308. However, in some examples, block 306 can be subsequent to block 308. In other words, blocks 306 and 308 of the example method 300 can be reversed in FIG. 3 when employing, for example, the lithography apparatus 200 of FIG. 2. In other words, the EUV light exposure of block 308 occurs prior to the UV light exposure of block 306.

The method 300 of FIG. 3 can be implemented as a part of a semiconductor manufacturing track 140 of FIG. 1. In some examples, one or more of the processes of FIG. 3 can be implemented by the processor circuitry 142 of FIG. 1 or FIG. 2. In some examples, the processor circuitry 142 can control and/or command advancement along a track providing the processes of FIG. 3. In some examples, the processor circuitry 142 can control and/or command advancement of a track for the processes of blocks 306 and/or 308 to control a duration of exposure to the photoresist layer 104. In some examples, the processor circuitry 142 can control and/or command the UV light source 116 to adjust (e.g., increase or decrease) an intensity of the UV light 108 at block 306 and/or can control or command the EUV light source 118 to adjust (e.g., increase or decrease) an intensity of the EUV light 110 at block 308. In some examples, the processor circuitry 142 can be configured to identify a type of photoresist material of the photoresist layer 104 and adjust the intensity and/or exposure duration at blocks 306 and/or308 based on the identified photoresist material. In some examples, the processor circuitry 142 can control advancement of a track and/or a wafer between an upstream station and block 302, between blocks 302 and 304, between blocks 304 and 306, between blocks 306 and 308 and/or between block 308 and a downstream station.

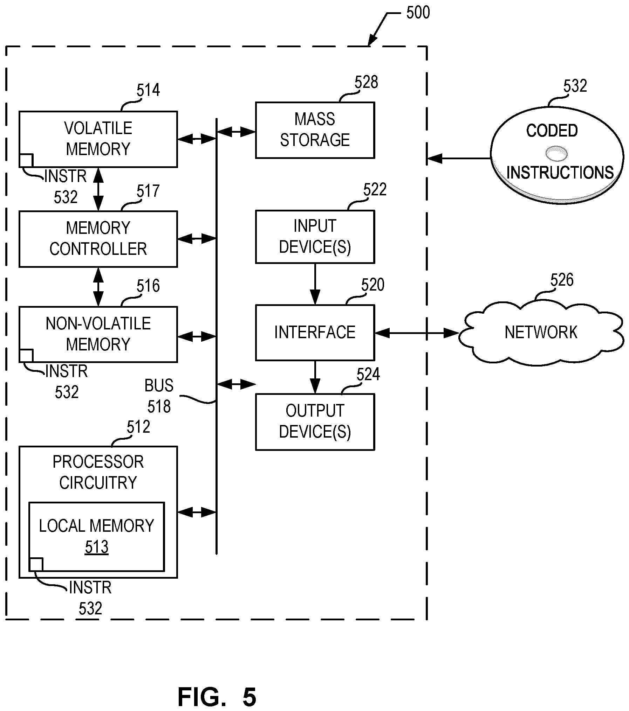

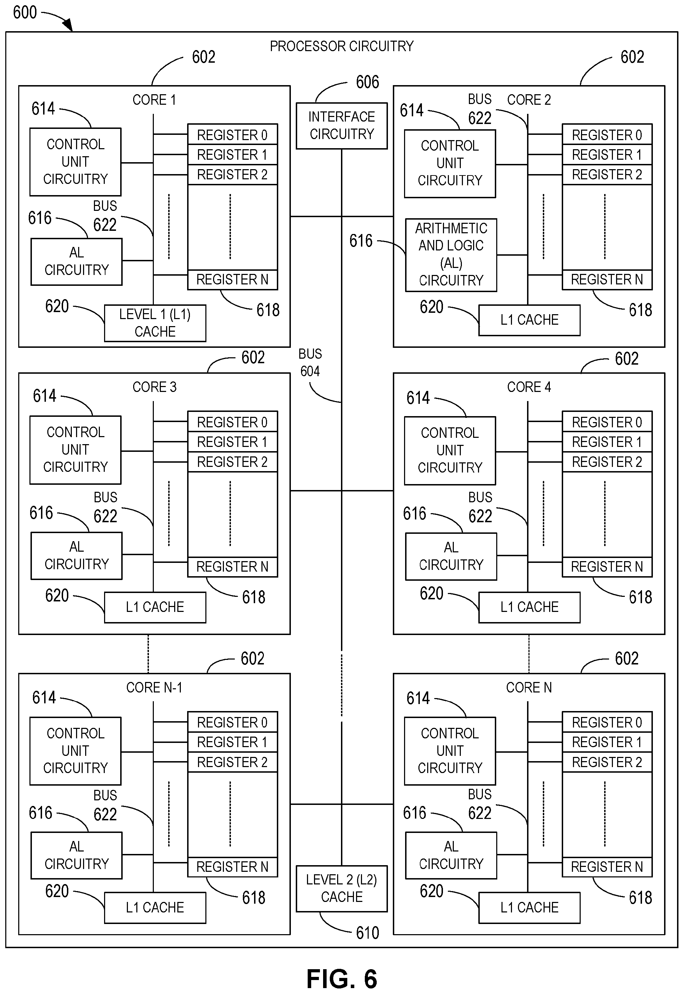

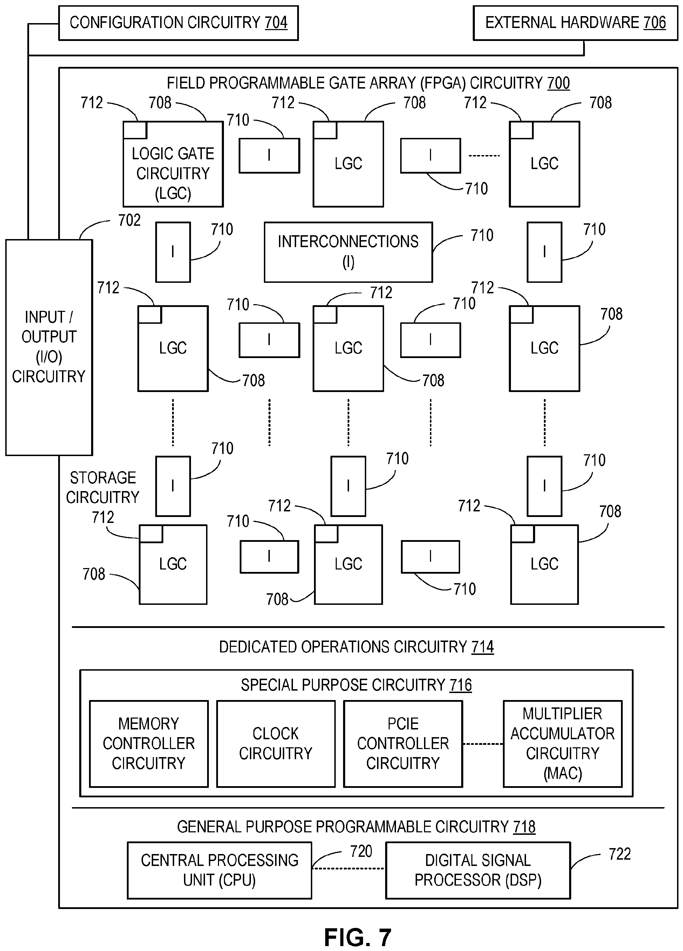

In some such example, FIG. 3 is representative of example machine readable instructions, which may be executed by programmable circuitry to implement and/or instantiate the processor circuitry 142 of FIG. 1 and/or representative of example operations which may be performed by programmable circuitry to implement and/or instantiate the processor circuitry 142 of FIG. 1, are shown in FIG. 3. The machine readable instructions may be one or more executable programs or portion(s) of one or more executable programs for execution by programmable circuitry such as the programmable circuitry 512 shown in the example processor platform 500 discussed below in connection with FIG. 5 and/or may be one or more function(s) or portion(s) of functions to be performed by the example programmable circuitry (e.g., an FPGA) discussed below in connection with FIGS. 6 and/or 7. In some examples, the machine readable instructions cause an operation, a task, etc., to be carried out and/or performed in an automated manner in the real world. As used herein, "automated" means without human involvement.

The program may be embodied in instructions (e.g., software and/or firmware) stored on one or more non-transitory computer readable and/or machine readable storage medium such as cache memory, a magnetic-storage device or disk (e.g., a floppy disk, a Hard Disk Drive (HDD), etc.), an optical-storage device or disk (e.g., a Blu-ray disk, a Compact Disk (CD), a Digital Versatile Disk (DVD), etc.), a Redundant Array of Independent Disks (RAID), a register, ROM, a solid-state drive (SSD), SSD memory, non-volatile memory (e.g., electrically erasable programmable read-only memory (EEPROM), flash memory, etc.), volatile memory (e.g., Random Access Memory (RAM) of any type, etc.), and/or any other storage device or storage disk. The instructions of the non-transitory computer readable and/or machine readable medium may program and/or be executed by programmable circuitry located in one or more hardware devices, but the entire program and/or parts thereof could alternatively be executed and/or instantiated by one or more hardware devices other than the programmable circuitry and/or embodied in dedicated hardware. The machine readable instructions may be distributed across multiple hardware devices and/or executed by two or more hardware devices (e.g., a server and a client hardware device). For example, the client hardware device may be implemented by an endpoint client hardware device (e.g., a hardware device associated with a human and/or machine user) or an intermediate client hardware device gateway (e.g., a radio access network (RAN)) that may facilitate communication between a server and an endpoint client hardware device. Similarly, the non-transitory computer readable storage medium may include one or more mediums. Further, although the example program is described with reference to the flowchart(s) illustrated in FIG. 3, many other methods of implementing the example processor circuitry 142 may alternatively be used. For example, the order of execution of the blocks of the flowchart(s) may be changed, and/or some of the blocks described may be changed, eliminated, or combined. Additionally or alternatively, any or all of the blocks of the flow chart may be implemented by one or more hardware circuits (e.g., processor circuitry, discrete and/or integrated analog and/or digital circuitry, an FPGA, an ASIC, a comparator, an operational-amplifier (op-amp), a logic circuit, etc.) structured to perform the corresponding operation without executing software or firmware. The programmable circuitry may be distributed in different network locations and/or local to one or more hardware devices (e.g., a single-core processor (e.g., a single core CPU), a multi-core processor (e.g., a multi-core CPU, an XPU, etc.)). For example, the programmable circuitry may be a CPU and/or an FPGA located in the same package (e.g., the same integrated circuit (IC) package or in two or more separate housings), one or more processors in a single machine, multiple processors distributed across multiple servers of a server rack, multiple processors distributed across one or more server racks, etc., and/or any combination(s) thereof.

The machine readable instructions described herein may be stored in one or more of a compressed format, an encrypted format, a fragmented format, a compiled format, an executable format, a packaged format, etc. Machine readable instructions as described herein may be stored as data (e.g., computer-readable data, machine-readable data, one or more bits (e.g., one or more computer-readable bits, one or more machine-readable bits, etc.), a bitstream (e.g., a computer-readable bitstream, a machine-readable bitstream, etc.), etc.) or a data structure (e.g., as portion(s) of instructions, code, representations of code, etc.) that may be utilized to create, manufacture, and/or produce machine executable instructions. For example, the machine readable instructions may be fragmented and stored on one or more storage devices, disks and/or computing devices (e.g., servers) located at the same or different locations of a network or collection of networks (e.g., in the cloud, in edge devices, etc.). The machine readable instructions may require one or more of installation, modification, adaptation, updating, combining, supplementing, configuring, decryption, decompression, unpacking, distribution, reassignment, compilation, etc., in order to make them directly readable, interpretable, and/or executable by a computing device and/or other machine. For example, the machine readable instructions may be stored in multiple parts, which are individually compressed, encrypted, and/or stored on separate computing devices, wherein the parts when decrypted, decompressed, and/or combined form a set of computer-executable and/or machine executable instructions that implement one or more functions and/or operations that may together form a program such as that described herein.

In another example, the machine readable instructions may be stored in a state in which they may be read by programmable circuitry, but require addition of a library (e.g., a dynamic link library (DLL)), a software development kit (SDK), an application programming interface (API), etc., in order to execute the machine-readable instructions on a particular computing device or other device. In another example, the machine readable instructions may need to be configured (e.g., settings stored, data input, network addresses recorded, etc.) before the machine readable instructions and/or the corresponding program(s) can be executed in whole or in part. Thus, machine readable, computer readable and/or machine readable media, as used herein, may include instructions and/or program(s) regardless of the particular format or state of the machine readable instructions and/or program(s).

The machine readable instructions described herein can be represented by any past, present, or future instruction language, scripting language, programming language, etc. For example, the machine readable instructions may be represented using any of the following languages: C, C++, Java, C#, Perl, Python, JavaScript, HyperText Markup Language (HTML), Structured Query Language (SQL), Swift, etc.

As mentioned above, the example operations of FIG. 3 may be implemented using executable instructions (e.g., computer readable and/or machine readable instructions) stored on one or more non-transitory computer readable and/or machine readable media. As used herein, the terms non-transitory computer readable medium, non-transitory computer readable storage medium, non-transitory machine readable medium, and/or non-transitory machine readable storage medium are expressly defined to include any type of computer readable storage device and/or storage disk and to exclude propagating signals and to exclude transmission media. Examples of such non-transitory computer readable medium, non-transitory computer readable storage medium, non-transitory machine readable medium, and/or non-transitory machine readable storage medium include optical storage devices, magnetic storage devices, an HDD, a flash memory, a read-only memory (ROM), a CD, a DVD, a cache, a RAM of any type, a register, and/or any other storage device or storage disk in which information is stored for any duration (e.g., for extended time periods, permanently, for brief instances, for temporarily buffering, and/or for caching of the information). As used herein, the terms "non-transitory computer readable storage device" and "non-transitory machine readable storage device" are defined to include any physical (mechanical, magnetic and/or electrical) hardware to retain information for a time period, but to exclude propagating signals and to exclude transmission media. Examples of non-transitory computer readable storage devices and/ or non-transitory machine readable storage devices include random access memory of any type, read only memory of any type, solid state memory, flash memory, optical discs, magnetic disks, disk drives, and/or redundant array of independent disks (RAID) systems. As used herein, the term "device" refers to physical structure such as mechanical and/or electrical equipment, hardware, and/or circuitry that may or may not be configured by computer readable instructions, machine readable instructions, etc., and/or manufactured to execute computer-readable instructions, machine-readable instructions, etc.

FIG. 5 is a block diagram of an example programmable circuitry platform 500 structured to execute and/or instantiate the example machine-readable instructions and/or the example operations of FIG. 3 to implement the processor circuitry 142. The programmable circuitry platform 500 can be, for example, a server, a personal computer, a workstation, a self-learning machine (e.g., a neural network), a mobile device (e.g., a cell phone, a smart phone, a tablet such as an iPad^{™}), an Internet appliance, a headset (e.g., an augmented reality (AR) headset, a virtual reality (VR) headset, etc.) or other wearable device, or any other type of computing and/or electronic device.

The programmable circuitry platform 500 of the illustrated example includes programmable circuitry 512. The programmable circuitry 512 of the illustrated example is hardware. For example, the programmable circuitry 512 can be implemented by one or more integrated circuits, logic circuits, FPGAs, microprocessors, CPUs, GPUs, DSPs, and/or microcontrollers from any desired family or manufacturer. The programmable circuitry 512 may be implemented by one or more semiconductor based (e.g., silicon based) devices. In this example, the programmable circuitry 512 implements the UV source 112, EUV source, and/or the lithography apparatus 100, 200.

The programmable circuitry 512 of the illustrated example includes a local memory 513 (e.g., a cache, registers, etc.). The programmable circuitry 512 of the illustrated example is in communication with main memory 514, 516, which includes a volatile memory 514 and a non-volatile memory 516, by a bus 518. The volatile memory 514 may be implemented by Synchronous Dynamic Random Access Memory (SDRAM), Dynamic Random Access Memory (DRAM), RAMBUS^{®} Dynamic Random Access Memory (RDRAM^{®}), and/or any other type of RAM device. The non-volatile memory 516 may be implemented by flash memory and/or any other desired type of memory device. Access to the main memory 514, 516 of the illustrated example is controlled by a memory controller 517. In some examples, the memory controller 517 may be implemented by one or more integrated circuits, logic circuits, microcontrollers from any desired family or manufacturer, or any other type of circuitry to manage the flow of data going to and from the main memory 514, 516.

The programmable circuitry platform 500 of the illustrated example also includes interface circuitry 520. The interface circuitry 520 may be implemented by hardware in accordance with any type of interface standard, such as an Ethernet interface, a universal serial bus (USB) interface, a Bluetooth^{®} interface, a near field communication (NFC) interface, a Peripheral Component Interconnect (PCI) interface, and/or a Peripheral Component Interconnect Express (PCIe) interface.

In the illustrated example, one or more input devices 522 are connected to the interface circuitry 520. The input device(s) 522 permit(s) a user (e.g., a human user, a machine user, etc.) to enter data and/or commands into the programmable circuitry 512. The input device(s) 522 can be implemented by, for example, an audio sensor, a microphone, a camera (still or video), a keyboard, a button, a mouse, a touchscreen, a trackpad, a trackball, an isopoint device, and/or a voice recognition system.

One or more output devices 524 are also connected to the interface circuitry 520 of the illustrated example. The output device(s) 524 can be implemented, for example, by display devices (e.g., a light emitting diode (LED), an organic light emitting diode (OLED), a liquid crystal display (LCD), a cathode ray tube (CRT) display, an in-place switching (IPS) display, a touchscreen, etc.), a tactile output device, a printer, and/or speaker. The interface circuitry 520 of the illustrated example, thus, typically includes a graphics driver card, a graphics driver chip, and/or graphics processor circuitry such as a GPU.

The interface circuitry 520 of the illustrated example also includes a communication device such as a transmitter, a receiver, a transceiver, a modem, a residential gateway, a wireless access point, and/or a network interface to facilitate exchange of data with external machines (e.g., computing devices of any kind) by a network 526. The communication can be by, for example, an Ethernet connection, a digital subscriber line (DSL) connection, a telephone line connection, a coaxial cable system, a satellite system, a beyond-line-of-sight wireless system, a line-of-sight wireless system, a cellular telephone system, an optical connection, etc.

The programmable circuitry platform 500 of the illustrated example also includes one or more mass storage discs or devices 528 to store firmware, software, and/or data. Examples of such mass storage discs or devices 528 include magnetic storage devices (e.g., floppy disk, drives, HDDs, etc.), optical storage devices (e.g., Blu-ray disks, CDs, DVDs, etc.), RAID systems, and/or solid-state storage discs or devices such as flash memory devices and/or SSDs.

The machine readable instructions 532, which may be implemented by the machine readable instructions of FIG. 3, may be stored in the mass storage device 528, in the volatile memory 514, in the non-volatile memory 516, and/or on at least one non-transitory computer readable storage medium such as a CD or DVD which may be removable.

FIG. 6 is a block diagram of an example implementation of the programmable circuitry 512 of FIG. 5. In this example, the programmable circuitry 512 of FIG. 5 is implemented by a microprocessor 600. For example, the microprocessor 600 may be a general-purpose microprocessor (e.g., general-purpose microprocessor circuitry). The microprocessor 600 executes some or all of the machine-readable instructions of the flowcharts of FIG. 3 to effectively instantiate the circuitry of FIG. 2 as logic circuits to perform operations corresponding to those machine readable instructions. In some such examples, the circuitry of FIG. 1 is instantiated by the hardware circuits of the microprocessor 600 in combination with the machine-readable instructions. For example, the microprocessor 600 may be implemented by multi-core hardware circuitry such as a CPU, a DSP, a GPU, an XPU, etc. Although it may include any number of example cores 602 (e.g., 1 core), the microprocessor 600 of this example is a multi-core semiconductor device including N cores. The cores 602 of the microprocessor 600 may operate independently or may cooperate to execute machine readable instructions. For example, machine code corresponding to a firmware program, an embedded software program, or a software program may be executed by one of the cores 602 or may be executed by multiple ones of the cores 602 at the same or different times. In some examples, the machine code corresponding to the firmware program, the embedded software program, or the software program is split into threads and executed in parallel by two or more of the cores 602. The software program may correspond to a portion or all of the machine readable instructions and/or operations represented by the flowchart of FIG. 3.

The cores 602 may communicate by a first example bus 604. In some examples, the first bus 604 may be implemented by a communication bus to effectuate communication associated with one(s) of the cores 602. For example, the first bus 604 may be implemented by at least one of an Inter-Integrated Circuit (I2C) bus, a Serial Peripheral Interface (SPI) bus, a PCI bus, or a PCIe bus. Additionally or alternatively, the first bus 604 may be implemented by any other type of computing or electrical bus. The cores 602 may obtain data, instructions, and/or signals from one or more external devices by example interface circuitry 606. The cores 602 may output data, instructions, and/or signals to the one or more external devices by the interface circuitry 606. Although the cores 602 of this example include example local memory 620 (e.g., Level 1 (L1) cache that may be split into an L1 data cache and an L1 instruction cache), the microprocessor 600 also includes example shared memory 610 that may be shared by the cores (e.g., Level 2 (L2 cache)) for high-speed access to data and/or instructions. Data and/or instructions may be transferred (e.g., shared) by writing to and/or reading from the shared memory 610. The local memory 620 of each of the cores 602 and the shared memory 610 may be part of a hierarchy of storage devices including multiple levels of cache memory and the main memory (e.g., the main memory 514, 516 of FIG. 5). Typically, higher levels of memory in the hierarchy exhibit lower access time and have smaller storage capacity than lower levels of memory. Changes in the various levels of the cache hierarchy are managed (e.g., coordinated) by a cache coherency policy.

Each core 602 may be referred to as a CPU, DSP, GPU, etc., or any other type of hardware circuitry. Each core 602 includes control unit circuitry 614, arithmetic and logic (AL) circuitry (sometimes referred to as an ALU) 616, a plurality of registers 618, the local memory 620, and a second example bus 622. Other structures may be present. For example, each core 602 may include vector unit circuitry, single instruction multiple data (SIMD) unit circuitry, load/store unit (LSU) circuitry, branch/jump unit circuitry, floating-point unit (FPU) circuitry, etc. The control unit circuitry 614 includes semiconductor-based circuits structured to control (e.g., coordinate) data movement within the corresponding core 602. The AL circuitry 616 includes semiconductor-based circuits structured to perform one or more mathematic and/or logic operations on the data within the corresponding core 602. The AL circuitry 616 of some examples performs integer based operations. In other examples, the AL circuitry 616 also performs floating-point operations. In yet other examples, the AL circuitry 616 may include first AL circuitry that performs integer-based operations and second AL circuitry that performs floating-point operations. In some examples, the AL circuitry 616 may be referred to as an Arithmetic Logic Unit (ALU).

The registers 618 are semiconductor-based structures to store data and/or instructions such as results of one or more of the operations performed by the AL circuitry 616 of the corresponding core 602. For example, the registers 618 may include vector register(s), SIMD register(s), general-purpose register(s), flag register(s), segment register(s), machine-specific register(s), instruction pointer register(s), control register(s), debug register(s), memory management register(s), machine check register(s), etc. The registers 618 may be arranged in a bank as shown in FIG. 6. Alternatively, the registers 618 may be organized in any other arrangement, format, or structure, such as by being distributed throughout the core 602 to shorten access time. The second bus 622 may be implemented by at least one of an I2C bus, a SPI bus, a PCI bus, or a PCIe bus.

Each core 602 and/or, more generally, the microprocessor 600 may include additional and/or alternate structures to those shown and described above. For example, one or more clock circuits, one or more power supplies, one or more power gates, one or more cache home agents (CHAs), one or more converged/common mesh stops (CMSs), one or more shifters (e.g., barrel shifter(s)) and/or other circuitry may be present. The microprocessor 600 is a semiconductor device fabricated to include many transistors interconnected to implement the structures described above in one or more integrated circuits (ICs) contained in one or more packages.

The microprocessor 600 may include and/or cooperate with one or more accelerators (e.g., acceleration circuitry, hardware accelerators, etc.). In some examples, accelerators are implemented by logic circuitry to perform certain tasks more quickly and/or efficiently than can be done by a general-purpose processor. Examples of accelerators include ASICs and FPGAs such as those discussed herein. A GPU, DSP and/or other programmable device can also be an accelerator. Accelerators may be on-board the microprocessor 600, in the same chip package as the microprocessor 600 and/or in one or more separate packages from the microprocessor 600.

FIG. 7 is a block diagram of another example implementation of the programmable circuitry 512 of FIG. 5. In this example, the programmable circuitry 512 is implemented by FPGA circuitry 700. For example, the FPGA circuitry 700 may be implemented by an FPGA. The FPGA circuitry 700 can be used, for example, to perform operations that could otherwise be performed by the example microprocessor 600 of FIG. 6 executing corresponding machine readable instructions. However, once configured, the FPGA circuitry 700 instantiates the operations and/or functions corresponding to the machine readable instructions in hardware and, thus, can often execute the operations/functions faster than they could be performed by a general-purpose microprocessor executing the corresponding software.

More specifically, in contrast to the microprocessor 600 of FIG. 6 described above (which is a general purpose device that may be programmed to execute some or all of the machine readable instructions represented by the flowchart(s) of FIG. 3 but whose interconnections and logic circuitry are fixed once fabricated), the FPGA circuitry 700 of the example of FIG. 7 includes interconnections and logic circuitry that may be configured, structured, programmed, and/or interconnected in different ways after fabrication to instantiate, for example, some or all of the operations/functions corresponding to the machine readable instructions represented by the flowchart(s) of FIG. 3. In particular, the FPGA circuitry 700 may be thought of as an array of logic gates, interconnections, and switches. The switches can be programmed to change how the logic gates are interconnected by the interconnections, effectively forming one or more dedicated logic circuits (unless and until the FPGA circuitry 700 is reprogrammed). The configured logic circuits enable the logic gates to cooperate in different ways to perform different operations on data received by input circuitry. Those operations may correspond to some or all of the instructions (e.g., the software and/or firmware) represented by the flowchart(s) of FIG. 3. As such, the FPGA circuitry 700 may be configured and/or structured to effectively instantiate some or all of the operations/functions corresponding to the machine readable instructions of the flowchart(s) of FIG. 3 as dedicated logic circuits to perform the operations/functions corresponding to those software instructions in a dedicated manner analogous to an ASIC. Therefore, the FPGA circuitry 700 may perform the operations/functions corresponding to the some or all of the machine readable instructions of FIG. 3 faster than the general-purpose microprocessor can execute the same.

In the example of FIG. 7, the FPGA circuitry 700 is configured and/or structured in response to being programmed (and/or reprogrammed one or more times) based on a binary file. In some examples, the binary file may be compiled and/or generated based on instructions in a hardware description language (HDL) such as Lucid, Very High Speed Integrated Circuits (VHSIC) Hardware Description Language (VHDL), or Verilog. For example, a user (e.g., a human user, a machine user, etc.) may write code or a program corresponding to one or more operations/functions in an HDL; the code/program may be translated into a low-level language as needed; and the code/program (e.g., the code/program in the low-level language) may be converted (e.g., by a compiler, a software application, etc.) into the binary file. In some examples, the FPGA circuitry 700 of FIG. 7 may access and/or load the binary file to cause the FPGA circuitry 700 of FIG. 7 to be configured and/or structured to perform the one or more operations/functions. For example, the binary file may be implemented by a bit stream (e.g., one or more computer-readable bits, one or more machine-readable bits, etc.), data (e.g., computer-readable data, machine-readable data, etc.), and/or machine-readable instructions accessible to the FPGA circuitry 700 of FIG. 7 to cause configuration and/or structuring of the FPGA circuitry 700 of FIG. 7, or portion(s) thereof.

In some examples, the binary file is compiled, generated, transformed, and/or otherwise output from a uniform software platform utilized to program FPGAs. For example, the uniform software platform may translate first instructions (e.g., code or a program) that correspond to one or more operations/functions in a high-level language (e.g., C, C++, Python, etc.) into second instructions that correspond to the one or more operations/functions in an HDL. In some such examples, the binary file is compiled, generated, and/or otherwise output from the uniform software platform based on the second instructions. In some examples, the FPGA circuitry 700 of FIG. 7 may access and/or load the binary file to cause the FPGA circuitry 700 of FIG. 7 to be configured and/or structured to perform the one or more operations/functions. For example, the binary file may be implemented by a bit stream (e.g., one or more computer-readable bits, one or more machine-readable bits, etc.), data (e.g., computer-readable data, machine-readable data, etc.), and/or machine-readable instructions accessible to the FPGA circuitry 700 of FIG. 7 to cause configuration and/or structuring of the FPGA circuitry 700 of FIG. 7, or portion(s) thereof.

The FPGA circuitry 700 of FIG. 7, includes example input/output (I/O) circuitry 702 to obtain and/or output data to/from example configuration circuitry 704 and/or external hardware 706. For example, the configuration circuitry 704 may be implemented by interface circuitry that may obtain a binary file, which may be implemented by a bit stream, data, and/or machine-readable instructions, to configure the FPGA circuitry 700, or portion(s) thereof. In some such examples, the configuration circuitry 704 may obtain the binary file from a user, a machine (e.g., hardware circuitry (e.g., programmable or dedicated circuitry) that may implement an Artificial Intelligence/Machine Learning (AI/ML) model to generate the binary file), etc., and/or any combination(s) thereof). In some examples, the external hardware 706 may be implemented by external hardware circuitry. For example, the external hardware 706 may be implemented by the microprocessor 600 of FIG. 6.

The FPGA circuitry 700 also includes an array of example logic gate circuitry 708, a plurality of example configurable interconnections 710, and example storage circuitry 712. The logic gate circuitry 708 and the configurable interconnections 710 are configurable to instantiate one or more operations/functions that may correspond to at least some of the machine readable instructions of FIG. 3 and/or other desired operations. The logic gate circuitry 708 shown in FIG. 7 is fabricated in blocks or groups. Each block includes semiconductor-based electrical structures that may be configured into logic circuits. In some examples, the electrical structures include logic gates (e.g., And gates, Or gates, Nor gates, etc.) that provide basic building blocks for logic circuits. Electrically controllable switches (e.g., transistors) are present within each of the logic gate circuitry 708 to enable configuration of the electrical structures and/or the logic gates to form circuits to perform desired operations/functions. The logic gate circuitry 708 may include other electrical structures such as look-up tables (LUTs), registers (e.g., flip-flops or latches), multiplexers, etc.

The configurable interconnections 710 of the illustrated example are conductive pathways, traces, vias, or the like that may include electrically controllable switches (e.g., transistors) whose state can be changed by programming (e.g., using an HDL instruction language) to activate or deactivate one or more connections between one or more of the logic gate circuitry 708 to program desired logic circuits.

The storage circuitry 712 of the illustrated example is structured to store result(s) of the one or more of the operations performed by corresponding logic gates. The storage circuitry 712 may be implemented by registers or the like. In the illustrated example, the storage circuitry 712 is distributed amongst the logic gate circuitry 708 to facilitate access and increase execution speed.

The example FPGA circuitry 700 of FIG. 7 also includes example dedicated operations circuitry 714. In this example, the dedicated operations circuitry 714 includes special purpose circuitry 716 that may be invoked to implement commonly used functions to avoid the need to program those functions in the field. Examples of such special purpose circuitry 716 include memory (e.g., DRAM) controller circuitry, PCIe controller circuitry, clock circuitry, transceiver circuitry, memory, and multiplier-accumulator circuitry. Other types of special purpose circuitry may be present. In some examples, the FPGA circuitry 700 may also include example general purpose programmable circuitry 718 such as an example CPU 720 and/or an example DSP 722. Other general purpose programmable circuitry 718 may additionally or alternatively be present such as a GPU, an XPU, etc., that can be programmed to perform other operations.

Although FIGS. 6 and 7 illustrate two example implementations of the programmable circuitry 512 of FIG. 5, many other approaches are contemplated. For example, FPGA circuitry may include an on-board CPU, such as one or more of the example CPU 720 of FIG. 6. Therefore, the programmable circuitry 512 of FIG. 5 may additionally be implemented by combining at least the example microprocessor 600 of FIG. 6 and the example FPGA circuitry 700 of FIG. 7. In some such hybrid examples, one or more cores 602 of FIG. 6 may execute a first portion of the machine readable instructions represented by the flowchart(s) of FIG. 3 to perform first operation(s)/function(s), the FPGA circuitry 700 of FIG. 7 may be configured and/or structured to perform second operation(s)/function(s) corresponding to a second portion of the machine readable instructions represented by the flowcharts of FIG. [Flowcharts], and/or an ASIC may be configured and/or structured to perform third operation(s)/function(s) corresponding to a third portion of the machine readable instructions represented by the flowcharts of FIG. 3.

It should be understood that some or all of the circuitry of FIG. [ER-Diagram] may, thus, be instantiated at the same or different times. For example, same and/or different portion(s) of the microprocessor 600 of FIG. 6 may be programmed to execute portion(s) of machine-readable instructions at the same and/or different times. In some examples, same and/or different portion(s) of the FPGA circuitry 700 of FIG. 7 may be configured and/or structured to perform operations/functions corresponding to portion(s) of machine-readable instructions at the same and/or different times.

In some examples, some or all of the circuitry of FIG. [ER-Diagram] may be instantiated, for example, in one or more threads executing concurrently and/or in series. For example, the microprocessor 600 of FIG. 6 may execute machine readable instructions in one or more threads executing concurrently and/or in series. In some examples, the FPGA circuitry 700 of FIG. 7 may be configured and/or structured to carry out operations/functions concurrently and/or in series. Moreover, in some examples, some or all of the circuitry of FIG. [ER-Diagram] may be implemented within one or more virtual machines and/or containers executing on the microprocessor 600 of FIG. 6.

In some examples, the programmable circuitry 512 of FIG. 5 may be in one or more packages. For example, the microprocessor 600 of FIG. 6and/or the FPGA circuitry 700 of FIG. 7 may be in one or more packages. In some examples, an XPU may be implemented by the programmable circuitry 512 of FIG. 5, which may be in one or more packages. For example, the XPU may include a CPU (e.g., the microprocessor 600 of FIG. 6, the CPU 720 of FIG. 7, etc.) in one package, a DSP (e.g., the DSP 722 of FIG. 7) in another package, a GPU in yet another package, and an FPGA (e.g., the FPGA circuitry 700 of FIG. 7) in still yet another package.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

Notwithstanding the foregoing, in the case of referencing a semiconductor device (e.g., a transistor), a semiconductor die containing a semiconductor device, and/or an integrated circuit (IC) package containing a semiconductor die during fabrication or manufacturing, "above" is not with reference to Earth, but instead is with reference to an underlying substrate on which relevant components are fabricated, assembled, mounted, supported, or otherwise provided. Thus, as used herein and unless otherwise stated or implied from the context, a first component within a semiconductor die (e.g., a transistor or other semiconductor device) is "above" a second component within the semiconductor die when the first component is farther away from a substrate (e.g., a semiconductor wafer) during fabrication/manufacturing than the second component on which the two components are fabricated or otherwise provided. Similarly, unless otherwise stated or implied from the context, a first component within an IC package (e.g., a semiconductor die) is "above" a second component within the IC package during fabrication when the first component is farther away from a printed circuit board (PCB) to which the IC package is to be mounted or attached. It is to be understood that semiconductor devices are often used in orientation different than their orientation during fabrication. Thus, when referring to a semiconductor device (e.g., a transistor), a semiconductor die containing a semiconductor device, and/or an integrated circuit (IC) package containing a semiconductor die during use, the definition of "above" in the preceding paragraph (i.e., the term "above" describes the relationship of two parts relative to Earth) will likely govern based on the usage context.

As used in this patent, stating that any part (e.g., a layer, film, area, region, or plate) is in anyway on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in anyway, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified herein.

As used herein "substantially real time" refers to occurrence in a near instantaneous manner recognizing there may be real world delays for computing time, transmission, etc. Thus, unless otherwise specified, "substantially real time" refers to real time + 1 second.

As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example, an integrated circuit may be implemented as one or more of an ASIC, an FPGA, a chip, a microchip, programmable circuitry, a semiconductor substrate coupling multiple circuit elements, a system on chip (SoC), etc.

From the foregoing, it will be appreciated that example systems, apparatus, articles of manufacture, and methods have been disclosed that enable lower doses or energy of extreme ultraviolet light to pattern photoresist layers of wafers and/or other semiconductor devices. Reducing the dose of EUV light for lithography patterning significantly decreases manufacturing cost and improves manufacturing throughput.

Further examples and combinations thereof include the following:
Example 1 includes a lithography apparatus having includes an ultraviolet (UV) source to expose a photoresist layer to UV light; and an extreme ultraviolet (EUV) source coupled to the UV source, the EUV source to expose the photoresist layer to EUV light to via a photomask, a combination of the UV light and the EUV light provide a pattern on the photoresist layer when a developer solution is applied to the photoresist layer.
Example 2 includes the apparatus of example 1, wherein the combination of the UV light and the EUV is sufficient to remove portion(s) of the photoresist layer based on the pattern provided on the photoresist layer when a developer solution is applied.
Example 3 includes the apparatus of example 2, wherein exposure of the UV light or the EUV light to the photoresist layer by themselves is insufficient to result in the removal of any portion(s) of the photoresist layer when the developer solution is applied.
Example 4 includes the apparatus of example 1, wherein a dose of EUV light is approximately 40 percent less to establish a critical dimension on the pattern of the photoresist layer as a result of the UV light exposure compared to a dose of energy needed absent exposure of the UV light.
Example 5 includes the apparatus of example 1, wherein the UV source disperses the UV light across an entire surface of the photoresist.
Example 6 includes the apparatus of example 1, wherein UV source includes a UV light source to provide the UV light.
Example 7 includes the apparatus of example 6, wherein the UV light source is a flood light.
Example 8 includes the apparatus of example 1, wherein EUV source patterns the photoresist based on a pattern provided by a photomask.
Example 9 includes the apparatus of example 1, wherein UV source and the EUV source are provided in a single housing.
Example 10 includes the apparatus of example 1, wherein the UV light source exposes the photoresist to the UV light prior to the EUV source exposing the photoresist to the EUV light.
Example 11 includes the apparatus of example 10, wherein the EUV light source exposes the photoresist to the EUV light prior to the UV source exposing the photoresist to the UV light.
Example 12 includes a method including exposing a photoresist layer of a wafer to a first dose of an ultraviolet (UV) light to alter property characteristics of the photoresist layer; and exposing the photoresist layer of the wafer to a second dose of an extreme ultraviolet (EUV) light, the first dose of the UV light and the second dose of the EUV light to contribute to a pattern of the photoresist layer.
Example 13 includes the method of example 12, further including providing the first dose of the UV light to the photoresist layer prior to the second dose of the EUV light.
Example 14 includes the method of example 12, further including providing the second dose of the EUV light to the photoresist layer prior to the first dose of the UV light.
Example 15 includes the method of example 12, further including providing the first dose of the UV light and the second dose of the EUV light in a semiconductor manufacturing track.
Example 16 includes a lithography apparatus including an ultraviolet (UV) source; an extreme ultraviolet (EUV) source; interface circuitry; machine readable instructions; and programmable circuitry to at least one of instantiate or execute the machine readable instructions to: cause the UV source to expose a photoresist layer of a wafer to a first dose of ultraviolet (UV) light across a surface of the photoresist layer; and cause the EUV source to expose the photoresist layer to a second dose of extreme ultraviolet (EUV) light via a patterned mask defining a pattern of openings.
Example 17 includes the apparatus of example 16, wherein the first dose of UV light and the second dose of EUV light are linked in a semiconductor manufacturing track to provide consistent first dose-to-second dose exposure time to improve wafer-to-wafer processing.
Example 18 includes the apparatus of example 16, wherein the programmable circuitry causes the photoresist to be exposed to the first dose of UV light for a first duration and causes the photoresist to be exposed to the second dose of EUV light for a second duration.
Example 19 includes the apparatus of example 16, wherein the programmable circuitry causes the wafer to move between the UV source and the EUV source.
Example 20 includes the apparatus of example 16, wherein a combination of the UV light and the EUV light provide a pattern on the photoresist layer when a developer solution is applied to the photoresist layer.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. A lithography apparatus comprising:
an ultraviolet (UV) source to expose a photoresist layer to UV light; and
an extreme ultraviolet (EUV) source coupled to the UV source, the EUV source to expose the photoresist layer to EUV light to via a photomask, a combination of the UV light and the EUV light provide a pattern on the photoresist layer when a developer solution is applied to the photoresist layer.

2. The apparatus of claim 1, wherein the combination of the UV light and the EUV is sufficient to remove portion(s) of the photoresist layer based on the pattern provided on the photoresist layer when a developer solution is applied.

3. The apparatus of any one of claims 1 and 2, wherein exposure of the UV light or the EUV light to the photoresist layer by themselves is insufficient to result in the removal of any portion(s) of the photoresist layer when the developer solution is applied.

4. The apparatus of any one of claims 1-3, wherein a dose of EUV light is approximately 40 percent less to establish a critical dimension on the pattern of the photoresist layer as a result of the UV light exposure compared to a dose of energy needed absent exposure of the UV light.

5. The apparatus of any one of claims 1-4, wherein the UV source disperses the UV light across an entire surface of the photoresist.

6. The apparatus of any one of claims 1-5, wherein UV source includes a UV light source to provide the UV light, and/or, wherein the UV light source is a flood light.

7. The apparatus of any one of claims 1-6, wherein EUV source patterns the photoresist based on a pattern provided by a photomask.

8. The apparatus of any one of claims 1-7, wherein the UV light source exposes the photoresist to the UV light prior to the EUV source exposing the photoresist to the EUV light.

9. The apparatus of any one of claims 1-8, wherein the EUV light source exposes the photoresist to the EUV light prior to the UV source exposing the photoresist to the UV light.

10. A method comprising:
exposing a photoresist layer of a wafer to a first dose of an ultraviolet (UV) light to alter property characteristics of the photoresist layer; and
exposing the photoresist layer of the wafer to a second dose of an extreme ultraviolet (EUV) light, the first dose of the UV light and the second dose of the EUV light to contribute to a pattern of the photoresist layer.

11. The method of claim 10, further including providing the first dose of the UV light to the photoresist layer prior to the second dose of the EUV light.

12. The method of any one of claims 10-11, further including providing the second dose of the EUV light to the photoresist layer prior to the first dose of the UV light.

13. The method of any one of claims 10-12, further including providing the first dose of the UV light and the second dose of the EUV light in a semiconductor manufacturing track.

14. The apparatus of any one of claims 1-9, further including:
interface circuitry;
machine readable instructions; and
programmable circuitry to at least one of instantiate or execute the machine readable instructions to:
cause the UV source to expose the photoresist layer to a first dose of the ultraviolet (UV); and
cause the EUV source to expose the photoresist layer to a second dose of the EUV light.

15. The apparatus of any one of claims 1-9 and 14, wherein at least one of:
the first dose of UV light and the second dose of EUV light are linked in a semiconductor manufacturing track to provide consistent first dose-to-second dose exposure time to improve wafer-to-wafer processing, or
the programmable circuitry causes the photoresist to be exposed to the first dose of UV light for a first duration and causes the photoresist to be exposed to the second dose of EUV light for a second duration.
